Europäisches Patentamt

European Patent Office

Office européen des brevets

(19)

(11) Numéro de publication: **0 074 674**
**B1**

(12) **FASCICULE DE BREVET EUROPEEN**

(45) Date de publication du fascicule du brevet: **01.06.88**

(51) Int. Cl.⁴: **H 03 K 19/007**

(21) Numéro de dépôt: **82200934.6**

(22) Date de dépôt: **22.07.82**

(54) **Circuits logiques de sécurité utilisables notamment en signalisation ferroviaire.**

(30) Priorité: **31.07.81 FR 8114945**

(43) Date de publication de la demande:
**23.03.83 Bulletin 83/12**

(45) Mention de la délivrance du brevet:
**01.06.88 Bulletin 88/22**

(84) Etats contractants désignés:
**BE CH DE FR GB IT LI NL SE**

(56) Documents cités:
**DE-A-1 413 959**
**FR-A-1 391 823**
**FR-A-1 398 923**
**FR-E- 85 339**

(73) Titulaire: **SOCIETE D'OPTIQUE, DE MECANIQUE D'ELECTRICITE ET DE RADIO O.M.E.R.A. - S.E.G.I.D.**
**49, rue Ferdinand Berthoud**
**F-95100 Argenteuil (FR)**
(84) **FR**

(73) Titulaire: **N.V. Philips' Gloeilampenfabrieken**
**Groenewoudseweg 1**
**NL-5621 BA Eindhoven (NL)**
(84) **BE CH DE GB IT LI NL SE**

(72) Inventeur: **Forward, Bernard Edouard**
**SOCIETE CIVILE S.P.I.D. 209 rue de l'Université**
**F-75007 Paris (FR)**

(74) Mandataire: **Pyronnet, Jacques et al**
**Société Civile S.P.I.D. 209 rue de l'Université**
**F-75007 Paris (FR)**

Courier Press, Leamington Spa, England.

# Description

L'invention concerne l'application à un circuit porte logique "ET" d'un circuit électronique de sécurité alimenté entre une tension continue de valeur algébrique $V_{cc}$ et la masse, comportant plusieurs transistors qui ont tous le même type de conduction, ayant deux signaux d'entrée Su et S'u dont les amplitudes ont des valeurs sensiblement égales, appliqués sur la base d'un premier transistor respectivement d'un deuxième transistor et un signal de sortie, ces trois signaux portant la valeur logique "1" lorsqu'il s'agit d'un signal rectangulaire de rapport cyclique 0,5 et la valeur logique "0" lorsqu'il s'agit d'un signal continu, l'un desdits transistors étant un transistor de sortie sur le collecteur duquel est prélevé ledit signal de sortie, les signaux d'entrée Su et S'u ayant à l'état 1, la même fréquence et étant opposés en phase.

L'invention concerne aussi l'application à un inverseur d'un circuit électronique de sécurité alimenté entre une tension continue de valeur algébrique $V_{cc}$ et la masse, comportant plusieurs transistors qui ont tous le même type de conduction, ayant deux signaux d'entrée Su et Sa dont les amplitudes ont des valeurs sensiblement égales, appliqués sur la base d'un premier transistor respectivement d'un second transistor et un signal de sortie, ces trois signaux portant la valeur logique "1" lorsqu'il s'agit d'un signal rectangulaire de rapport cyclique 0,5 et la valeur logique "0" lorsqu'il s'agit d'un signal continu, Sa étant égal à 1 pour le fonctionnement en inverseur, l'un desdits transistors étant un transistor de sortie sur le collecteur duquel est prélevé ledit signal de sortie, les signaux d'entrée Su et Sa ayant, à l'état 1, la même fréquence et étant opposés en phase.

De plus, l'invention concerne l'application à un temporisateur à l'attraction et à la chute élémentaire d'un circuit de sécurité alimenté entre une tension continue de valeur algébrique $V_{cc}$ et la masse, comportant plusieurs transistors qui ont tous le même type de conduction, ayant un signal d'entrée Su appliqué sur la base d'un premier transistor et un signal de sortie, ces deux signaux portant la valeur logique "1" lorsqu'il s'agit d'un signal rectangulaire de rapport cylindrique 0,5 et la valeur logique "0" lorsqu'il s'agit d'un signal continu, l'un desdits transistors étant un transistor de sortie sur le collecteur duquel est prélevé ledit signal de sortie, la base du deuxième transistor étant reliée au collecteur du premier transistor par l'intermédiaire d'une résistance de façon telle que les signaux appliqués aux bases des premier et deuxième transistors soient, à l'état 1, de même fréquence et opposés en phase.

De tels circuits logiques dont l'élaboration est particulière du fait qu'ils doivent satisfaire à des normes de sécurité assez sévères, sont utilisés notamment dans la signalisation ferroviaire dans des détecteurs de passage d'un véhicule sur une voie ferrée. Ces détecteurs sont connus sous le nom de pédales.

En ce qui concerne les pédales électroniques, deux capteurs disposés en des points déterminés de la voie réagissent par influence au passage d'un véhicule en émettant ou en interrompant un signal propre à chaque capteur. Les deux signaux sont reçus et traités par le détecteur dont la sortie commande un relais d'utilisateur qui actionne à son tour un dispositif d'annonce ou par exemple la fermeture (respectivement l'ouverture) d'un passage à niveau. Tout incident anormal qui peut être une séquence incorrecte au niveau des capteurs ou bien une panne ou un défaut intervenant dans le détecteur doit avoir pour conséquence un état de sécurité supérieur à celui qui existait avant l'incident. Par exemple, l'incident en question doit provoquer la fermeture d'un passage à niveau et inhiber sa réouverture.

Des circuits logiques utilisés dans la boîte de traitement de pédales électroniques de voie ferrée sont notamment des temporisateurs à l'attraction, des circuits-portes "ET", des inverseurs, des mémoires positives ou négatives, des temporisateurs à la chute.

On connaît des pédales électropneumatiques actionnées mécaniquement lors du passage d'un train, chaque capteur comportant un levier qui est heurté par la roue lors de son passage. Le train passant généralement à vitesse élevée, l'usure de tels capteurs est grande et ils doivent être changés au bout de un à deux ans. Cet inconvénient a conduit à remplacer les pédales électropneumatiques par des pédales électroniques. Dans ce dernier cas, la temporisation à la chute, par exemple, utile après le passage du dernier essieu ne pouvant plus être réalisée par action pneumatique, doit être réalisée électroniquement dans la boîte de traitement, ce qui complique la logique de cette dernière.

On connaît des pédales électroniques, par exemple du brevet français 1 319 441. Les pédales de ce type utilisent des oscillateurs commandés par les signaux d'entrée de la boîte de traitement. Or les automatismes en logique de sécurité intrinsèque deviennent de plus en plus complexes et nécessitent des temps de réponse plus rapides, ces temps de réponse étant liés en grande partie à l'augmentation très nette de la vitesse des trains. Il s'avère nécessaire de trouver d'autres systèmes que le système connu constitué par un "ET" logique dont les signaux d'entrée sont les alimentations d'un oscillateur dont on redresse le signal de sortie pour pouvoir en alimenter un second. Ce système devient caduc lorsque les entrées varient rapidement dans le temps non seulement à cause de l'inertie propre de l'oscillateur mais par la grande difficulté à trouver un compromis pour le condensateur de filtrage qui doit être de valeur suffisante pour assurer sa fonction de filtrage mais assez faible pour se décharger entre deux passages à "zéro" rapprochés d'une des grandeurs d'entrée. Cette logique est donc inopérante lorsque les grandeurs d'entrée passent plusieurs fois de l'état "1" à l'état "0" et vice versa en une milliseconde comme c'est le cas pour les signaux des capteurs d'une pédale électronique lors du passage d'un train à 300 km/h.

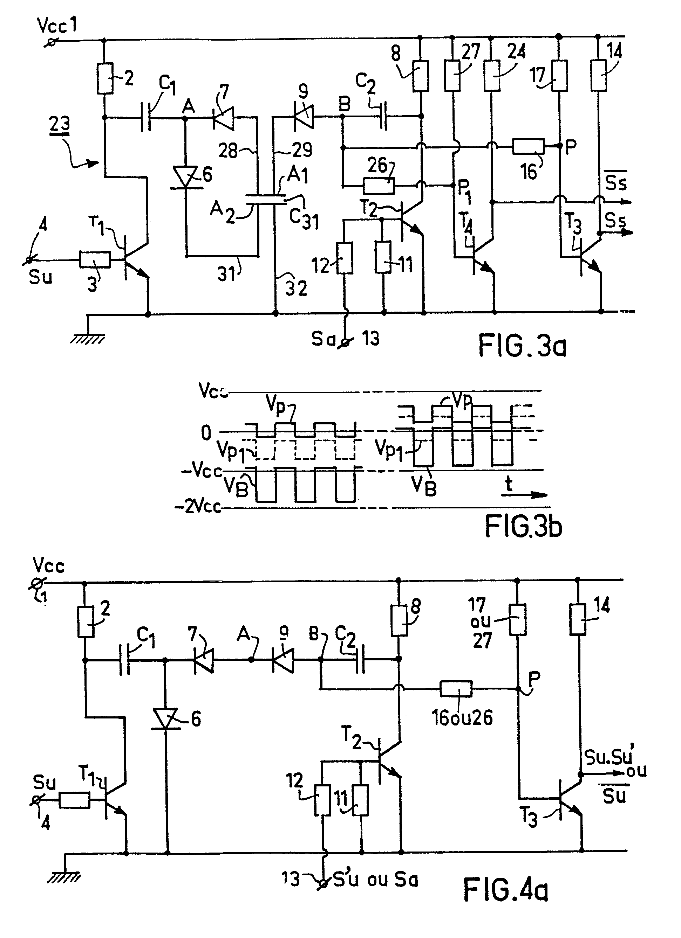

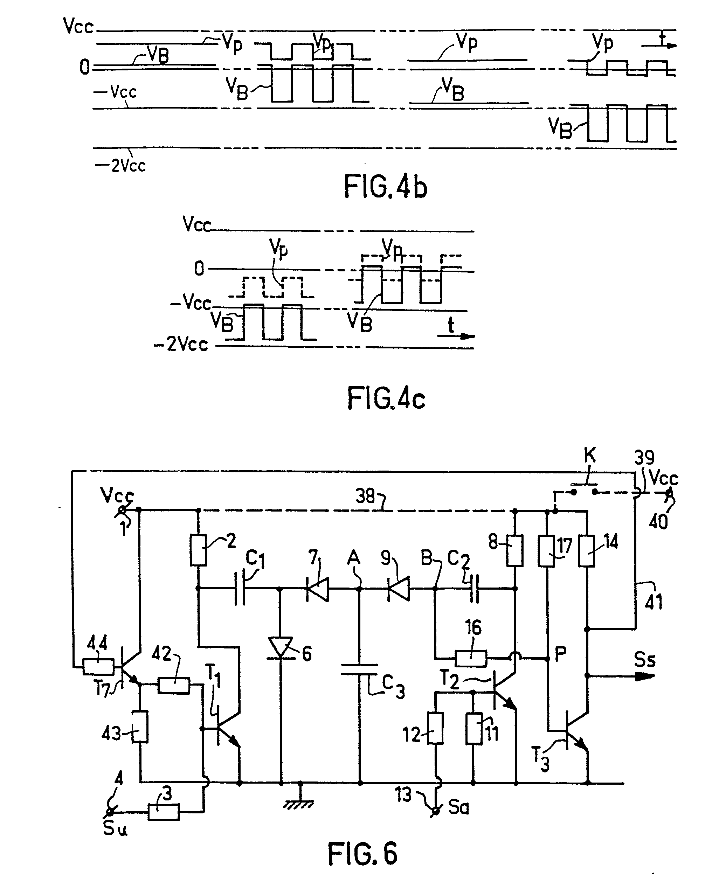

On connaît aussi du brevet français 1 391 823 et de son addition 85 339 des circuits logiques de sécurité du type "ET" comportant (Figure 4) en combinaison, une pompe à diodes constituée d'un premier transistor (20), de diodes (29, 37) et d'au moins un condensateur (25), un sous-ensemble constitué par un deuxième transistor (9) et un condensateur de décalage (14) de tension ayant une armature reliée au collecteur dudit deuxième transistor et l'autre armature reliée à la borne d'alimentation à la tension (−V) par un groupe de deux résistances (16,8) en série dont le point commun est relié à la base d'un troisième transistor (1) constituant un étage de sortie.

Les signaux d'entrée sont des signaux carrés en phase appliqués respectivement aux bases (21, 10) du premier (20) et du deuxième (9) transistor et le signal de sortie est prélevé sur le collecteur du troisième transistor.

Un but de l'invention est de réaliser des circuits logiques de sécurité dont les régimes transitoires de fonctionnement puissent être brefs.

Un autre but de l'invention est de réaliser des circuits logiques de sécurité répondant à diverses fonctions logiques de façon sensiblement modulaire, chaque type de circuit logique étant constitué pour l'essentiel par un sous ensemble électronique ayant la même structure.

Tout en conservant les avantages de l'art antérieur, l'application à un circuit porte logique "ET" du circuit logique selon l'invention indiquée au premier paragraphe permet d'atteindre les buts fixés ci-dessus grâce au fait que ledit circuit comporte en combinaison en premier lieu une pompe à diodes, constituée dudit premier transistor, de diodes, d'un condensateur et d'un condensateur de décalage de tension, destinée à porter le potentiel d'un premier point à une valeur continue prédéterminée comprise entre 0 et $-V_{cc}$ lorsque Su=1, et S'u=0, en second lieu un sous ensemble constitué par ledit deuxième transistor et ledit condensateur de décalage de tension qui a une armature reliée au collecteur dudit deuxième transistor et l'autre armature reliée audit premier point, ledit sous ensemble étant destiné à additionner audit premier point une tension alternative en opposition de phase avec S'u lorsque S'u=1, ledit premier point étant relié à la borne d'alimentation à la tension $V_{cc}$ par un groupe de deux résistances en série constituant un diviseur de tension dont le point commun est relié à la base dudit transistor de sortie, et lesdites deux résistances en série ayant des valeurs telles que ledit point commun est le siège d'une tension qui oscille autour de 0 si et seulement si Su=S'u=1.

De même, l'application à un inverseur d'un circuit logique indiqué au deuxième paragraphe est remarquable en ce que ledit circuit comporte en combinaison en premier lieu une pompe à diodes, constituée dudit premier transistor, de diodes, d'un condensateur et d'un condensateur de décalage de tension, destinée à porter le potentiel d'un premier point à une valeur continue prédéterminée comprise entre 0 et $-V_{cc}$ lorsque Su=1 et Sa=0, en second lieu un sous ensemble constitué par ledit deuxième transistor et ledit condensateur de décalage de tension qui a une armature reliée au collecteur dudit deuxième transistor et l'autre armature reliée audit premier point, ledit sous ensemble étant destiné à additionner audit premier point une tension alternative en opposition de phase avec Sa lorsque Sa=1, ledit premier point étant relié à la borne d'alimentation à la tension $V_{cc}$ par un groupe de deux résistances en série constituant un diviseur de tension dont le point commun est relié à la base dudit transistor de sortie, et lesdites deux résistances en série ayant des valeurs telles que ledit point commun est le siège d'une tension qui oscille autour de 0 si et seulement si Su=0.

De même, l'application à un temporisateur à l'attraction et à la chute d'un circuit logique indiqué au troisième paragraphe est remarquable en ce que ledit circuit comporte en combinaison en premier lieu une pompe à diodes, constituée dudit premier transistor, de diodes, d'un condensateur et d'un condensateur de décalage de tension alimentant en tension un premier point, en second lieu un sous ensemble constitué par ledit deuxième transistor et ledit condensateur de décalage de tension qui a une armature reliée au collecteur dudit deuxième transistor et l'autre armature reliée audit premier point, ladite pompe à diodes et ledit sous ensemble étant destinés à créer audit premier point une tension qui est le résultat de l'addition d'une tension continue prédéterminée comprise entre 0 et $-V_{cc}$ et d'une tension alternative en phase avec Su, lorsque Su=1, la capacité du condensateur de décalage de tension étant élevée et ledit premier point étant relié à la borne d'alimentation à la tension $V_{cc}$ par un groupe de deux résistances en série constituant un diviseur de tension dont le point commun est relié à la base dudit transistor de sortie, et lesdites deux résistances en série ayant des valeurs telles que ledit point commun est le siège d'une tension qui oscille autour de 0 lorsque Su=1 avec un retard prédéterminé par rapport à la transition: Su=0/Su=1.

La structure électronique ainsi obtenue peut encore être utilisée pour l'élaboration de temporisateurs à l'attraction ou à la chute.

Notamment, l'application d'un circuit logique selon l'invention à un temporisateur à l'attraction est remarquable en ce que la tension $V_{cc}$ est appliquée audit premier point après la transition: Su=1/Su=0 par un circuit de remise à zéro (RAZ) branché sur la base du premier transistor par l'intermédiaire d'une résistance et audit premier point, ce circuit RAZ comportant une pompe à diodes suivie d'un étage à deux transistors.

L'application d'un circuit logique selon l'invention à un temporisateur à la chute est remarquable en ce que le circuit logique comporte au moins un circuit porte logique "ET" dont la capacité de $C_2$ est élevée, qui reçoit un signal d'entrée Su sur la base du premier transistor et un signal auxiliaire Sa opposé en phase à Su lorsque Su=Sa=1 sur la base du deuxième transistor et dont la sortie est reliée à l'entrée de signal auxiliaire d'une mémoire positive à une entrée de signal utile et une entrée de signal auxiliaire, l'entrée de signal utile Su du circuit-porte logique "ET" situé en amont étant reliée à l'entrée de signal utile de ladite mémoire dont la sortie s'identifie à celle du temporisateur à la chute.

Certains temporisateurs à la chute peuvent comporter plusieurs circuits portes "ET" reliés en cascade, la sortie de l'un étant reliée à l'entrée de signal utile du suivant, et la sortie de chaque circuit porte "ET" étant reliée à une entrée d'un circuit porte "OU" dont la sortie est reliée à l'entrée de signal auxiliaire de ladite mémoire positive.

La description qui suit en regard des dessins annexés, le tout donné à titre d'exemple, fera bien comprendre comment l'invention peut être réalisée.

La figure 1a est le schéma électronique d'une cellule de base selon l'invention et la figure 1b un diagramme de temps de certains signaux servant à expliciter son fonctionnement.

La figure 2 est un schéma synoptique de la chaîne de traitement du signal issu d'un capteur, incorporant un circuit logique de sécurité pour l'élaboration des signaux selon l'invention.

La figure 3a est le schéma électronique du circuit logique de sécurité pour l'élaboration des signaux selon l'invention, et la figure 3b un diagramme de temps de certains signaux servant à expliciter son fonctionnement.

La figure 4a est le schéma électronique d'un circuit-porte logique "ET" ou d'un inverseur selon l'invention.

La figure 4b est un diagramme de temps de certains signaux servant à expliciter le fonctionnement du circuit-porte "ET" représenté à la figure 4a.

La figure 4c est un diagramme de temps de certains signaux servant à expliciter le fonctionnement de l'inverseur représenté à la figure 4a.

La figure 5 est le schéma électronique d'un temporisateur à l'attraction incorporant un circuit de RAZ selon l'invention.

La figure 6 est le schéma électronique d'une mémoire de sécurité positive selon l'invention.

La figure 7 est le schéma synoptique d'un temporisateur à l'attraction, incorporant un circuit de RAZ et une mémoire de contrôle de RAZ selon l'invention.

La figure 8 est le schéma synoptique d'un temporisateur à la chute selon l'invention.

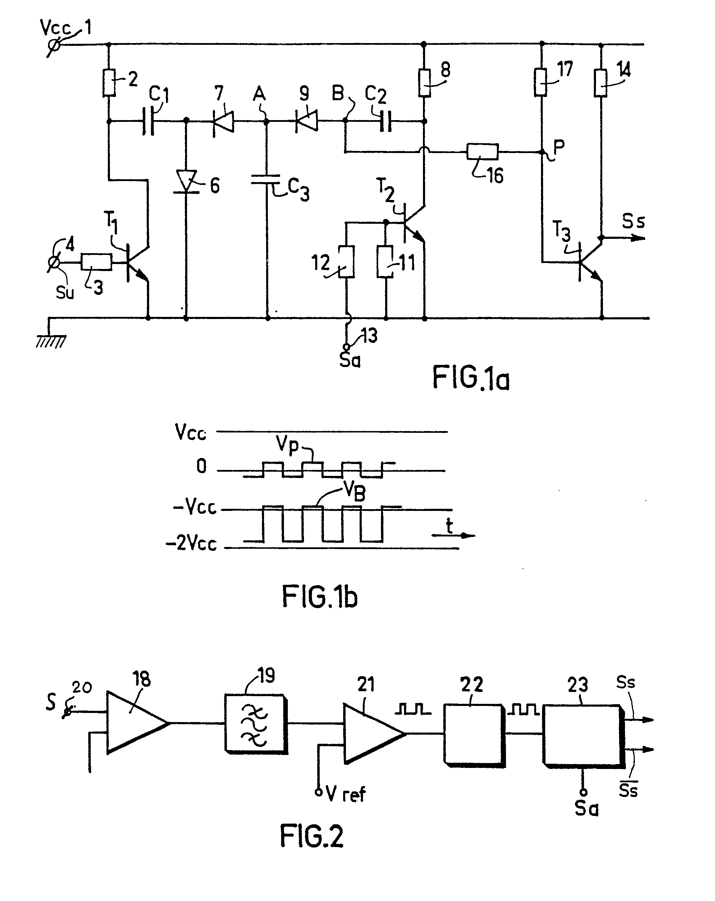

Entre un conducteur d'alimentation qui reçoit sur une borne 1 une tension continue par exemple positive $V_{cc}$ et la masse, la figure 1a représente une cellule de base selon l'invention. Cette cellule comporte un premier transistor NPN $T_1$ dont le collecteur est relié à la borne d'alimentation 1 par une résistance 2 et l'émetteur à la masse. La base de $T_1$ reçoit, par l'intermédiaire d'une résistance 3 un signal utile Su appliqué à une borne d'entrée 4, qui est considéré comme portant la valeur logique "1" lorsqu'il est alternatif avec une fréquence prédéterminée et carré (rapport cyclique voisin de 0,5) et comme étant à "0" lorsqu'il est continu. Une pompe à diodes au moins constituée par un condensateur $C_1$ et deux diodes 6 et 7 sert à porter le potentiel d'un premier point A à une valeur comprise entre 0 et $-V_{cc}$. Le condensateur $C_1$ et la diode 6 dans le sens passant disposés en série shuntent le trajet collecteur-émetteur de $T_1$ et le point A est relié par l'intermédiaire de la diode 7 dans le sens passant au point commun aux éléments $C_1$ et 6. Dans le cas de la cellule de base, un condensateur tampon $C_3$ qui fait partie de la pompe à diodes relie le point A à la masse. Lorsque le transistor $T_1$ est bloqué, $C_1$ se charge à travers la diode 6 avec une polarité positive du côté du collecteur de $T_1$. Lorsque $T_1$ est saturé, $C_1$ se décharge dans $C_3$ à travers la diode 7, la polarité positive de $C_3$ étant située du côté de la masse. Sous l'influence d'un signal logique "1" (Su=1) brusquement appliqué sur la borne 4. $T_1$ est alternativement saturé et bloqué et $C_3$ se charge progressivement, de façon que la tension du point A soit un peu plus négative à chaque cycle, jusqu'à atteindre une valeur légèrement supérieure à $-V_{cc}$. La cellule de base comporte en outre un sous ensemble constitué par un deuxième transistor NPN $T_2$, avec une résistance de collecteur 8, et un condensateur de décalage de tension $C_2$ branché entre le collecteur de $T_2$ et un deuxième point B lui-même relié au point A par l'intermédiaire d'une diode dans le sens passant, 9. La base de $T_2$ est reliée à la masse par une résistance de polarisation 11 et, par l'intermédiaire d'une résistance 12 à une borne 13 qui est le siège d'un signal auxiliaire $S_a$, de même nature que $S_u$, mais dont la fréquence peut être différente de celle de $S_u$, à l'état logique "1". Le point A faisant office de source de tension négative, lorsque $T_2$ est bloqué, $C_2$ se charge à la tension $2 V_{cc}$ avec une polarité positive du côté du collecteur de $T_2$, le point B portant alors sensiblement la même tension que le point A. Lorsque $T_2$ se sature le potentiel sur les deux armatures de $C_2$ décroît brutalement de la valeur $V_{cc}$ de façon que la tension en B devient égale à une valeur légèrement supérieure à $-2 V_{cc}$. Lorsque $S_u$ et $S_a$ sont tous deux égaux à "1", la tension en B alterne de $-V_{cc}$ à $-2 V_{cc}$ en première approximation, à la fréquence de $S_a$. La cellule de base comporte aussi un étage de sortie constitué par un troisième transistor $T_3$, avec une résistance de collecteur 14, et un groupe de deux résistances 16 et 17, disposées en série entre le point B et la borne 1 et dont le point commun P (troisième point) est relié à la base de $T_3$. Le signal de sortie $S_s$ de la cellule de base est prélevé sur le collecteur de $T_3$. Les valeurs des résistances 16 et 17 sont déterminées de façon telle qu'en régime permanent et pour $S_u$ et $S_a$ égaux à "1", la tension du point P alterne autour de 0 au rythme de $S_a$. On a représenté à la figure 1b les tensions des points B et P indiquées par $V_B$ et $V_P$ lors de ce fonctionnement. Dans ces conditions, le signal de sortie $S_s$ est le siège d'un signal logique "1", de même fréquence que $S_a$ et en phase avec $S_a$. Lorsque le signal $S_u$ et/ou le signal $S_a$ est à l'état logique "0", le signal $S_s$ est à l'état logique "0".

Lorsque $S_u$ et $S_a$ sont à l'état "1", compte tenu des valeurs de $C_1$, $C_3$ et de la fréquence de $S_u$, il faut un certain temps pour que $V_A$ devienne sensiblement égal à $-V_{cc}$. Le signal de sortie $S_s$ n'apparaît qu'au bout d'un délai qui est fonction des capacités de $C_1$, $C_3$, de la fréquence de $S_u$ et aussi des valeurs de $R_5$ et de $R_6$ dont le rapport fixe la tension $V_P$.

La charge de $C_2$ s'effectue en prélevant une partie de l'énergie de $C_3$. De ce fait $C_3$ se trouve chargé grâce à $C_1$ et se décharge en partie par $C_2$. Aussi pour optimiser le circuit, il faut que $S_u$ et $S_a$ soient de même fréquence et en opposition de phase. Lorsque c'est le cas, il est possible d'omettre le condensateur tampon $C_3$, tout en obtenant le même fonctionnement que celui décrit ci-dessus, et le bon fonctionnement du nouveau circuit ainsi obtenu est alors une garantie que l'opposition de phase entre les signaux $S_u$ et $S_a$ est bien respectée, ce qui peut être souhaitable pour des raisons de sécurité.

La fréquence des signaux $S_u$ et $S_a$ est par exemple de l'ordre de quelques dizaines de kHz et les valeurs de certains composants de la cellule de base sont par exemple les suivantes:

$C_1$: 6,8 nF
$C_2$: 2,2 nF
$C_3$: de quelques dizaines de nF à quelques µF
Résistance 16: 51 kΩ
Résistance 17: 36 kΩ

La figure 2 montre la chaîne de traitement du signal issu d'un capteur. On a vu dans les paragraphes précédents que les signaux utilisés dans les circuits logiques de sécurité de l'invention doivent être alternatifs, de forme rectangulaire avec un rapport cyclique 0,5 et éventuellement de même fréquence et déphasés de II les uns par rapport aux autres (cas du "ET" logique notamment comme décrit ci-dessous en référence à la figure 4a). Or les signaux disponibles ne satisfont en général à aucun des critères précités. D'où la nécessité d'élaborer des signaux répondant auxdits critères.

Les signaux reçus (S) en provenance de capteurs de voie notamment sont des signaux alternatifs (rectangulaires ou sinusoïdaux). Il peut aussi s'agir de signaux continus qui sont alors préalablement transformés en signaux sinusoïdaux au moyen d'un oscillateur.

La figure 2 représente le montage en cascade, entre une borne d'entrée 20, siège d'un signal S, et deux bornes de sortie complémentaires $S_s$ et $\overline{S}_s$, d'un amplificateur 18, un filtre passe-bande 19, un comparateur 21, un circuit de mise en forme 22 et un circuit logique de sécurité pour l'élaboration des signaux selon l'invention, 23. La détection d'un signal S qui doit être transformé en signal utile a lieu à travers les éléments 18, 19 et 21. Après amplification en 18 la fréquence de S (39 khz ou 50 kHz par exemple) est sélectionnée à travers le filtre passe-bande 19 et son amplitude est comparée en 21 à une tension de seuil $V_{ref}$ appliquée à une deuxième entrée du comparateur 21. Le signal S n'est transmis à la sortie de 21 que lorsque son amplitude est supérieure à celle de $V_{ref}$. Le signal issu du comparateur 21 est rectangulaire mais avec un rapport cyclique différent de 0,5 généralement. Le circuit de mise en forme 22, par exemple un "trigger de Schmidt", permet l'obtention d'un signal carré, (de rapport cyclique 0,5) à la même fréquence, comme indiqué sur la figure 2. Le signal est ensuite traité en 23 comme décrit ci-dessous en référence aux figures 3a et 3b.

Sur la figure 3a les mêmes références désignent les mêmes éléments que sur la figure 1a avec les mêmes fonctions mais avec des valeurs qui peuvent être différentes. A la place du condensateur $C_3$, un condensateur à sécurité à armatures contrôlées $C_{31}$ est utilisé. Un deuxième étage de sortie, semblable à l'étage $T_3$, 14, 16 et 17 est utilisé pour obtenir le signal $\overline{S}_s$ complémentaire du signal $S_s$. Ce deuxième étage est constitué par le transistor $T_4$ avec sa résistance de collecteur 24 et le groupe de résistances 26 et 27 qui ont en commun le point $P_1$. Le choix des valeurs des résistances 26 et 27 est tel que lorsque $S_u$ et $S_a$ sont à l'état "1" la tension de $P_1$, $V_{P1}$, reste inférieure à 0 (partie gauche de la figure 3b) et que lorsque $S_u$ est à l'état "0" $S_a$ étant à l'état "1" (partie droite de la figure 3b) la tension $V_{P1}$ alterne autour de 0. Ce fonctionnement est explicité à la figure 3b sur laquelle $V_B$ figure en trait plein en bas, $V_P$ en trait plein en haut et $V_{P1}$ en trait interrompu. On remarquera que lorsque $S_u$ et $S_a$ sont à l'état "1", $S_s$ est à l'état "1", $\overline{S}_s$ étant à l'état "0" (tension continue $V_{cc}$) et que lorsque $S_u$ est à l'état "0" et $S_a$ à l'état "1", $\overline{S}_s$ est à l'état "1", $S_s$ étant à l'état "0" (tension nulle).

Le circuit 23 sert notamment à effectuer un changement de fréquence: $S_u$ étant, à l'état "1" par exemple à la fréquence 39 kHz ou 50 kHz et $S_a$ à 20 kHz, on obtient pour $S_s$ un signal de sortie à 20 kHz.

Pour l'élaboration des signaux, il est nécessaire pour des raisons de sécurité que le condensateur tampon soit à armatures contrôlées et comporte à cet effet quatre conducteurs de liaison, le conducteur 28 relié à l'anode de la diode 7, le conducteur 29 relié à la cathode de la diode 9, le conducteur 31 relié à la cathode de la diode 6 et le conducteur 32 relié à la masse. Si le condensateur tampon était analogue à $C_3$ (figure 1a) et qu'il existe une coupure de l'un ou l'autre conducteur de liaison, on se retrouverait ainsi avec un circuit électronique fonctionnant par intermittence. En effet, conformément à ce qui est décrit ci-dessus sur la présence ou l'absence de $C_3$, lorsque $S_u$ et $S_a$ sont à l'état "1" avec des fréquences différentes, tantôt $S_u$ et $S_a$ seraient en opposition de phase ce qui se traduirait par $S_s$ à l'état "1" et $\overline{S}_s$ à l'état "0", tantôt $S_u$ et $S_a$ seraient en phase, ce qui se traduirait par $S_s$ à l'état "0" et $\overline{S}_s$ à l'état "1". Donc, vu du dispositif électronique situé en aval du bloc d'élaboration, tout se passerait comme si $S_u$ disparaissait et réapparaissait, ce qui peut être contraire à la sécurité. En revanche, si le condensateur $C_{31}$ est utilisé et que la coupure se produit en 28 ou 29 (figure 3a), alors $C_2$ ne peut plus être chargé entre $V_{cc}$ et $-V_{cc}$, $S_s$ est à l'état "0" et $\overline{S}_s$ à l'état "1" quel que soit l'état logique de $S_u$. Si la coupure se produit en 31 ou 32, le résultat obtenu est le même mais pour une raison différente: la diode 6 ayant sa cathode déconnectée, $C_1$ ne peut plus se charger et par voie de conséquence $C_{31}$ non plus. De ce fait $C_2$ ne peut plus être chargé à $-V_{cc}$. Donc, tout cas de coupure de $C_{31}$ est considéré comme une disparition définitive de $S_u$, ce qui va dans le sens de la sécurité au sens ferroviaire du terme.

En résumé, le circuit conforme à la figure 2 permet d'élaborer à partir d'une grandeur analogique de forme d'onde quelconque et de fréquence sélectionnée, un signal alternatif carré de rapport cyclique 0,5, de fréquence définie (fréquence de $S_a$ la deuxième entrée du circuit 23) ainsi qu'un signal complémentaire au sens booléen du terme, le système étant de sécurité intrinsèque.

Les valeurs de certains composants du circuit 23 pour l'élaboration des signaux sont par exemple les suivantes:

$C_1$: 10 nF
$C_2$: 10 nF
$C_{31}$: 4,7 nF
résistance 16: 51 kΩ
résistance 17: 36 kΩ
résistance 26: 22 kΩ
résistance 27: 51 kΩ

La figure 4a représente la structure d'une cellule de base, dans laquelle le condensateur $C_3$ n'est pas utilisé, destinée à fonctionner soit comme un circuit-porte "ET", soit comme un inverseur selon les valeurs données au groupe de résistances de l'étage de sortie. Le condensateur $C_3$ est supprimé car les deux signaux d'entrée sont, à l'état "1", de même fréquence (typiquement égale à 20 kHz) et déphasés sensiblement de II, et l'on souhaite que lorsqu'il n'en est pas ainsi, le circuit "ET" ou l'inverseur produise un signal de sortie logique "0", ce qui va dans le sens de la sécurité, la panne ainsi provoquée permettant de déceler la non conformité des signaux d'entrée aux formes d'onde qui doivent exister en fonctionnement normal. Lorsque les deux signaux alternatifs qui doivent être fournis au circuit de la figure 4a sont en phase, il est prévu de déphaser l'un d'eux de II avant de l'appliquer à la borne 4 ou 13. Ceci est réalisé de façon connue, par exemple à l'aide d'un montage à transistor(s). Le condensateur $C_3$ étant supprimé, il est possible de remplacer les deux diodes 7 et 9 par une diode unique. Pour des questions de normalisation du circuit à celui de la cellule de base, cependant, les deux diodes 7 et 9 sont, de préférence, conservées.

Si le circuit de la figure 4a est destiné à réaliser un circuit-porte "ET" à deux entrées, les deux entrées sont le siège de deux signaux utiles $S_u$ et $S'_u$, pouvant prendre les états logiques "0" ou "1", les états "1" étant tels que décrits au paragraphe précédent, et les résistances appartenant au groupe de résistances à l'étage de sortie sont du type 16 et 17 (voir figure 1a et figure 3a et la description qui s'y rapporte). La figure 4b permet d'expliciter le fonctionnement du circuit-porte "ET" en donnant une représentation des tensions $V_B$ et $V_P$ par rapport aux quatre niveaux de tension: $V_{cc}$, 0, $-V_{cc}$ et $-2\,V_{cc}$, comme sur les figures 1b et 3b. Les quatre phases de fonctionnement représentées à la figure 4b correspondent aux couples d'états logiques des entrées respectifs suivants, vus de gauche à droite: $S_u$ et $S'_u$ à "0", $S_u$ à "0" et $S'_u$ à "1", $S_u$ à "1" et $S'_u$ à "0", $S_u$ et $S'_u$ à "1". Dans les trois premiers cas, le signal de sortie est à "0" et dans le quatrième, à "1", ce qui réalise bien la fonction ET.

Si le circuit de la figure 4a est destiné à réaliser un inverseur, la borne d'entrée 4 est le siège d'un signal utile $S_u$ et la borne d'entrée 13 reçoit un signal auxiliaire $S_a$ normalement toujours à l'état "1", les signaux $S_u$ et $S_a$ devant présenter, à l'état "1" les mêmes caractéristiques de fréquence et de phase que les signaux $S_u$ et $S'_u$ déjà décrits. Les résistances appartenant au groupe de résistances de l'étage de sortie sont du type 26 et 27 (voir figure 3a et la description qui s'y rapporte). Le fonctionnement en inverseur se déduit aisément des valeurs des tensions $V_B$ et $V_P$ représentées à la figure 4c: concernant la partie gauche de cette figure, $S_u$ et $S_a$ sont à l'état "1", le transistor $T_3$ est bloqué et la sortie est à la tension $V_{cc}$, soit à l'état logique "0". Concernant la partie droite $S_u$ est à l'état "0", $S_a$ à l'état "1", $T_1$ est alternativement saturé et bloqué et la sortie alternativement à la tension 0 et $V_{cc}$, à la fréquence de $S_a$, ce qui réalise bien la fonction $\overline{S}_u$. Dans le circuit de la figure 4a les valeurs de capacité $C_1$ et $C_2$ sont par exemple respectivement égales à 6,8 nF et 2,2 nF.

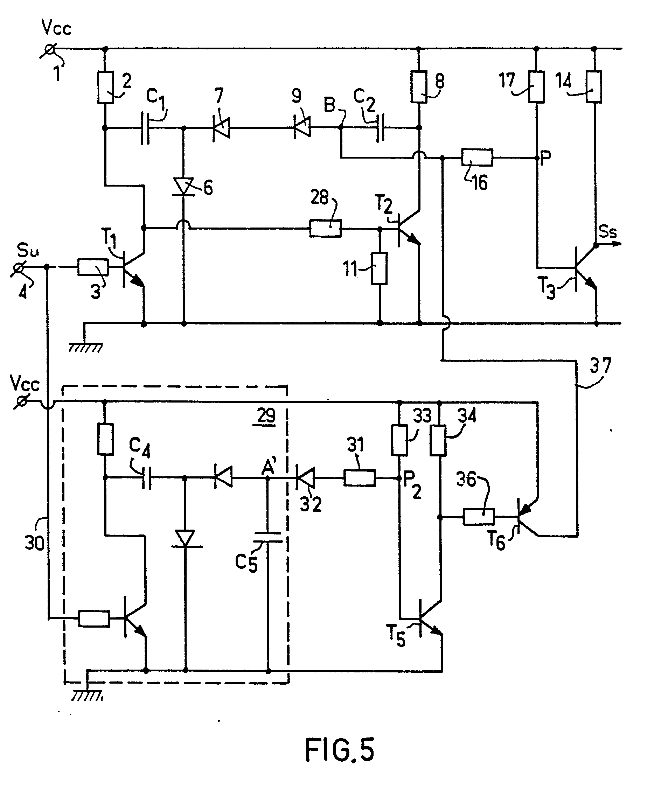

La figure 5 représente un temporisateur à l'attraction (TA) avec un circuit de RAZ. La partie haute du schéma représente le TA élémentaire dont la structure est très proche de celle de la cellule de base, les mêmes références désignant les mêmes éléments avec les mêmes fonctions. Le condensateur $C_3$ est absent et, pour assurer l'opposition de phase, nécessaire dans ce cas entre le signal sur la base de $T_1$ et le signal sur la base de $T_2$, la base de $T_2$ est reliée au collecteur de $T_1$ par l'intermédiaire d'une résistance 28. Le signal $S_u$ sur la borne 4 constitue l'entrée unique du TA élémentaire. La temporisation, de l'ordre de plusieurs secondes est assurée par le condensateur $C_2$ dont la capacité est de plusieurs ordres de grandeur plus élevée que dans les circuits logiques décrits précédemment. Par exemple, la capacité de $C_2$ est égale à 100 µF, celle de $C_1$ étant de 3,9 nF. Le TA élémentaire décrit ci-dessus qui crée un retard par exemple égal à 5 s entre l'apparition de $S_u$ et l'apparition de $S_s$ est en même temps un temporisateur à la chute (TC) à cause de la capacité élevée de $C_2$. Or il est généralement souhaitable qu'un TA ne soit pas un TC. Dans ce but, le circuit de la figure 5 comporte à sa partie inférieure un circuit de RAZ branché entre la borne 4 et le point B du TA élémentaire, dont la fonction est de décharger très rapidement le condensateur $C_2$ dès le passage de "1" à "0" du signal $S_u$. La partie gauche 29 du circuit RAZ délimitée par un rectangle en trait interrompu et reliée à la borne 4 par un conducteur 30 est une pompe à diodes semblable à celle de la cellule de base et destinée à porter la tension du point A' homologue du point A à la valeur $-V_{cc}$ en présence d'un signal alternatif à l'entrée. La partie droite du circuit de RAZ est un circuit de sortie à deux transistors: un point $P_2$ est relié au point A' par l'intermédiaire d'une résistance 31 et d'une diode 32 dans le sens passant, à l'alimentation $V_{cc}$ par l'intermédiaire d'une résistance 33 et à la base d'un transistor NPN $T_5$ dont l'émetteur est relié directement à la masse et le collecteur à l'alimentation $V_{cc}$ par l'intermédiaire d'une résistance 34. Le collecteur de $T_5$ est aussi relié par l'intermédiaire d'une résistance 36 à la base d'un transistor PNP $T_6$ dont l'émetteur est relié à l'alimentation $V_{cc}$ et le collecteur au point B du TA élémentaire par le conducteur de sortie 37. Le choix des valeurs des résistances 31 et 33 est tel que lorsque le signal $S_u$ passe de l'état "0" à l'état "1", le point A' étant sensiblement à $-V_{cc}$, le point $P_2$ est porté à une tension négative, ce qui bloque le transistor $T_5$ et par voie de conséquence le transistor $T_6$. Dans ces conditions, aucun courant ne passe dans le conducteur 37, tout se passe comme si le circuit de RAZ était absent et le temporisateur fonctionne en TA comme décrit ci-dessus, étant donné que les valeurs de capacités de $C_4$ (équivalent de $C_1$) et de $C_5$ (équivalent de $C_3$) sont très faibles et par exemple égales à 6,8 nF pour $C_4$ et à 47 nF pour $C_5$. Par contre, lorsque $S_u$ passe de l'état "1" à l'état "0", le point A' est porté presque instantanément à une tension voisine de zéro, le point $P_2$ à une tension positive comprise entre 0 et $V_{cc}$, les transistors $T_5$ et $T_6$ sont rendus passants, et le point B est porté à la tension $V_{cc}$, ce qui provoque la décharge très rapide de $C_2$ à travers la résistance 8, et par suite le passage rapide du signal $S_s$ de l'état "1" à l'état "0", la tension $V_{cc}$ étant présente en 8 pendant tout le temps où $S_u$ est à l'état "0". La présence du circuit de RAZ permet donc au temporisateur de fonctionner uniquement en TA (et pas en TC). Le fonctionnement en TA seul est important lors de passages successifs de $S_u$ de l'état "1" à l'état "0" et réciproquement à un rythme dont la période est nettement inférieure au temps prévu pour la temporisation à l'attraction. Un exemple d'une telle séquence est le passage d'un train tel que lors du passage de chaque essieu du train au-dessus du capteur, $S_u$ est porté à l'état "1" alors qu'il est à "0" entre deux essieux, la temporisation à l'attraction qui est exploitée étant celle qui commence au passage du dernier essieu. Avec un TA élémentaire $C_2$ se chargerait et se déchargerait alternativement au rythme du passage des essieux de façon telle que la charge de $C_2$ augmenterait progressivement lors du passage de chaque essieu sans toutefois faire passer $S_s$ à l'état "1". Lors de l'instant de passage du dernier essieu, la charge de $C_2$ ne serait pas négligeable, en dépendance de la vitesse du train et du nombre d'essieux, ce qui fausserait le temps d'apparition de $S_s$ par rapport audit instant, en raccourcissant ce temps par rapport au temps prédéterminé de temporisation à l'attraction. Grâce au circuit de RAZ, le condensateur $C_2$ se décharge complètement entre le passage de deux essieux successifs et le temps de temporisation à l'attraction prédéterminé après le passage du dernier essieu est bien respecté. Comme c'est le cas pour tout circuit de sécurité utilisé en signalisation ferroviaire, toute panne doit être envisagée et il faut vérifier que cette panne conduit à un état de sécurité supérieur à celui qui existait avant la panne.

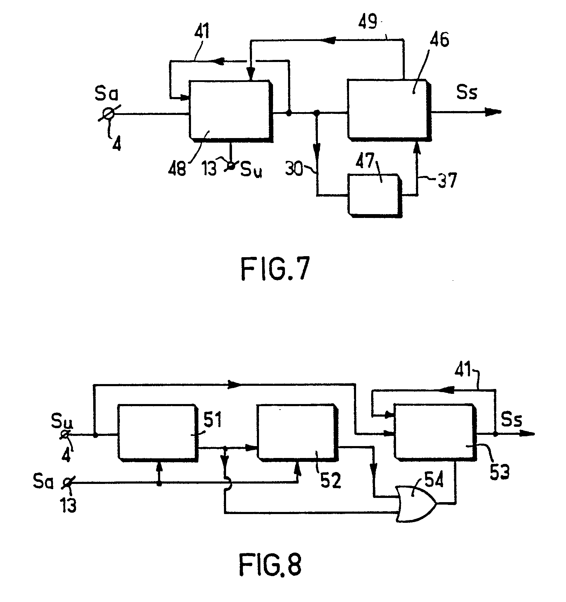

Le circuit de RAZ peut, en particulier, être sujet à des pannes qui, étant donné son raccordement au TA élémentaire peuvent réagir sur ce dernier de deux façons: quel que soit l'état logique de $S_u$, ou bien le potentiel du point B est maintenu à la tension $V_{cc}$ (cas de la coupure du conducteur 30 notamment), ou bien le potentiel du point B n'est plus soumis à l'action du circuit de RAZ (cas de coupure du conducteur 37 notamment). Dans le premier cas, le signal $S_s$ est toujours à l'état "0", ce qui va dans le sens d'une sécurité accrue. Dans le deuxième cas, par contre, le TA présente le défaut indiqué ci-dessus, ce défaut pouvant toutefois permettre le fonctionnement de l'ensemble logique (de la pédale par exemple) mais avec une variation incontrôlable du temps de temporisation à l'attraction, ce qui peut entraîner une diminution de la sécurité. Pour éviter ce mauvais fonctionnement, on peut adjoindre au circuit de la figure 5 une mémoire de sécurité telle que décrite en référence à la figure 6.

Le circuit représenté à la figure 6 est une mémoire positive, c'est-à-dire qu'elle mémorise l'apparition d'un signal alternatif sur une borne d'entrée, en l'occurrence le passage du signal utile $S_u$ sur l'entrée 4 de l'état "0" à l'état "1" quelles que soient les transitions logiques ultérieures de $S_u$. Dans sa version la plus simple, la mémoire comporte le conducteur en trait interrompu 38 et ne comporte pas le conducteur en trait interrompu 39 qui reçoit sur une borne 40 la tension $V_{cc}$. Dans cette version, une partie de la mémoire est constituée par la cellule de base, ce qui est indiqué par les mêmes références. Le signal auxiliaire $S_a$ sur la borne 13 est normalement toujours présent. Cependant, la borne 13 peut constituer une entrée de validation, la mémoire étant validée lorsque $S_a$ est à l'état "1" et non validée lorsque $S_a$ est à l'état "0". En supplément par rapport à la cellule de base la mémoire comporte un conducteur de rebouclage 41 qui relie le collecteur de $T_3$ à un étage d'entrée constitué par un transistor $T_7$ et trois résistances 42, 43, 44. Le collecteur de $T_7$ est relié à la borne 1, son émetteur à la base de $T_1$ par l'intermédiaire de la résistance 42 et à la masse par l'intermédiaire de la résistance 43, et sa base au conducteur 41 par l'intermédiaire de la résistance 44. $S_a$ étant à l'état "1" la transition "0"→"1" de $S_u$ provoque presque immédiatement celle de $S_s$ et le rebouclage de la sortie de $T_3$ sur la base de $T_1$.

Si $S_u$ passe alors à l'état "0" la sortie $S_s$ se maintient à l'état "1", une fonction "OU" logique étant réalisée sur la base de $T_1$ entre les signaux $S_u$, et $S_s$ ramené à l'entrée. Il faut noter que la mémoire ne comporte pas d'oscillateur, sa fréquence de fonctionnement étant celle du signal auxiliaire $S_a$. On remarquera d'autre part que lors du fonctionnement de la mémoire, dans le cas où $S_s$ est à l'état "1" et $S_u$ à "0", le signal présent sur la base de $T_1$ est en phase avec $S_s$ et par suite avec $S_a$. La présence du condensateur tampon $C_3$ est donc indispensable dans ce cas.

Selon une autre version de la mémoire, le conducteur 38 est remplacé par le conducteur 39 qui est relié aux bornes d'alimentation des résistances 8, 14 et 17 par l'intermédiaire d'un interrupteur K qui dépend par exemple de la fermeture ou de l'ouverture d'un contact de relais d'utilisateur. Lorsque l'interrupteur K est fermé, la mémoire fonctionne comme décrit ci-dessus. Lorsque K est ouvert, le signal $S_a$ est à l'état "0" quel que soit l'état des entrées de signaux logiques $S_u$ et $S_a$. Ceci constitue un deuxième moyen possible pour valider la mémoire, avec la particularité suivante: il peut être souhaitable qu'un même signal logique, qui passe de façon fugitive à l'état "1" soit présent sur la borne 4 et provoque seulement ensuite la fermeture de l'interrupteur K, mais que l'on souhaite tout de même sa mémorisation, alors que lors de son apparition en 4 la mémoire n'est pas encore validée. Cette mémorisation est possible moyennant que l'écart de temps entre la présence de l'état "1" en 4 et l'instant de fermeture de K soit faible et que la capacité du condensateur $C_3$ soit déterminée en conséquence de manière que son temps de décharge soit supérieur audit écart de temps.

La figure 7 représente un TA élémentaire 46 avec RAZ 47 ainsi que leurs conducteurs de liaison 30 et 37 et une mémoire de contrôle de RAZ 48 disposée en amont de l'ensemble 46, 47. La mémoire 48 est par exemple du type comportant le conducteur 38 et ne comportant pas le conducteur 39. Les signaux d'entrée sont intervertis, $S_u$ étant appliqué à la borne 13 et $S_a$ à la borne 4. Un conducteur 49 relie le point B du TA élémentaire à un montage connu à un transistor, deux diodes et une résistance, non représenté, placé comme un étage d'entrée supplémentaire de la mémoire et dont la fonction est de transmettre l'état "1" du signal logique $S_a$ à la base du transistor $T_1$ de la mémoire lorsque le conducteur 49 est le siège de la tension $V_{cc}$ et de transformer cet état "1" en l'état "0" sur la base de $T_1$ lorsque le conducteur 49 est à tension sensiblement nulle. La borne d'entrée 4 devient ainsi une entrée de validation telle que le passage à l'état "1" du signal $S_u$ ne peut être transmis, à travers la mémoire 48, en entrée du TA 46 et de sa RAZ 47 que si, pendant l'état "0" de $S_u$ précédant son passage à l'état "1", la tension $V_{cc}$ est appliquée par la RAZ 47 au point B du TA élémentaire 46. Le montage électronique conforme au schéma de la figure 7 constitue donc un TA ne fonctionnant pas en TC et tel que toute panne a pour conséquence le passage et le maintien à l'état "0" du signal $S_s$, quel que soit l'état logique du signal $S_u$.

Le schéma synoptique de la figure 8 représente un temporisateur à la chute (TC) comportant une première cellule de base 51, une deuxième cellule de base 52, une mémoire 53 et un circuit-porte "OU" 54. La cellule 51 reçoit le signal $S_u$ sur sa borne 4 et le signal $S_a$ sur sa borne 13 (non représentée). La cellule 52 reçoit sur son entrée 4 (non représentée) le signal de sortie de la cellule 51, et le signal $S_a$ sur sa borne 13 (non représentée). La mémoire 53 reçoit sur sa borne 4 (non représentée) le signal $S_u$ et sur sa borne 13 (non représentée) le signal de sortie du circuit-porte "OU" 54 dont les deux entrées sont reliées aux sorties respectives des cellules 51 et 52. Les capacités des condensateurs $C_1$, $C_2$ et $C_3$ de la mémoire 53 sont faibles de façon que le temps de réponse de la mémoire soit faible. Le TC de la figure 8 a un temps de TA au moins égal aux temps de TA cumulés de la cellule 51 et de la mémoire 53.

Par contre, son temps de TC est égal aux temps de TC cumulés des éléments 51, 52 et 53, d'où l'intérêt d'introduire un nombre de cellules de base disposées en série d'autant plus grand que l'on souhaite diminuer le temps de TA et augmenter le temps de TC. Il faut noter que le TC le plus simple pour lequel un temps de TA non négligeable ne serait pas gênant, comporte une seule cellule de base dont la sortie est reliée directement à la borne 13 de la mémoire 53. Ces circuits électroniques devant être de sécurité, sont conçus de façon telle que la défection de n'importe quel composant entraîne l'impossibilité de leur fonctionnement. Un aperçu de cette contrainte est décrit ci-dessus en référence au mauvais fonctionnement éventuel du circuit de RAZ du TA ou au choix du condensateur à armatures contrôlées $C_{31}$ dans le circuit d'élaboration des signaux. Par défection d'un composant, on entend notamment:

— compure d'une résistance (seule envisagée étant donné le type de résistance choisi en sécurité ferroviaire),

— court-circuit ou coupure d'un condensateur ou d'une diode,

— coupure d'une électrode de transistor, court-circuit entre deux électrodes d'un transistor, courant de fuite $I_cB_o$.

Deux pannes simultanées ne sont envisagées que si la première n'est pas détectée.

Il va de soi qu'il est possible de mettre en oeuvre l'invention en faisant fonctionner tous les circuits décrits ci-dessus entre les tensions 0 et $-V_{cc}$, moyennant le remplacement des transistors NPN par des transistors PNP et du transistor PNP ($T_6$) par un transistor NPN.

L'invention ne se limite pas à la signalisation ferroviaire. Elle s'applique d'une façon générale à tout automatisme requérant une très grande sécurité de fonctionnement.

## Revendications

1. Application à un circuit porte logique "ET" d'un circuit électronique de sécurité (figure 4a) alimenté entre une tension continue de valeur algébrique $V_{cc}$ et la masse, comportant plusieurs transistors ($T_1$, $T_2$, $T_3$) qui ont tous le même type de conduction, ayant deux signaux d'entrée Su et S'u dont les amplitudes ont des valeurs sensiblement égales, appliqués sur la base d'un premier transistor ($T_1$) respectivement d'un deuxième transistor ($T_2$) et un signal de sortie, ces trois signaux portant la valeur logique "1" lorsqu'il s'agit d'un signal rectangulaire de rapport cyclique 0,5 et la valeur logique "0" lorsqu'il s'agit d'un signal continu, l'un desdits transistors ($T_3$) étant un transistor de sortie sur le collecteur duquel est prélevé ledit signal de sortie (Su · S'u), les signaux d'entrée Su et S'u ayant à l'état 1, la même fréquence et étant opposés en phase, ledit circuit comportant en combinaison en premier lieu une pompe à diodes, constituée dudit premier transistor ($T_1$), de diodes (6, 7), d'un condensateur ($C_1$) et d'un condensateur de décalage de tension ($C_2$), destinée à porter le potentiel d'un premier point (A, B) à une valeur continue prédéterminée comprise entre 0 et $-V_{cc}$ lorsque Su=1, et S'u=0, en second lieu un sous ensemble constitué par ledit deuxième transistor ($T_2$) et ledit condensateur de décalage de tension ($C_2$) qui a une armature reliée au collecteur dudit deuxième transistor ($T_2$) et l'autre armature reliée audit premier point (A, B), ledit sous ensemble étant destiné à additionner audit premier point une tension alternative en opposition de phase avec S'u lorsque S'u=1, ledit premier point étant relié à la borne d'alimentation à la tension $V_{cc}$ par un groupe de deux résistances en série (16, 17) constituant un diviseur de tension dont le point commun (P) est relié à la base dudit transistor de sortie ($T_3$), et lesdites deux résistances en série ayant des valeurs telles que ledit point commun (P) est le siège d'une tension qui oscille autour de 0 si et seulement si Su=S'u=1.

2. Application à un inverseur d'un circuit électronique de sécurité (figure 4a) alimenté entre une tension continue de valeur algébrique $V_{cc}$ et la masse, comportant plusieurs transistors ($T_1$, $T_2$, $T_3$) qui ont tous le même type de conduction, ayant deux signaux d'entrée Su et Sa dont les amplitudes ont des valeurs sensiblement égales, appliqués sur la base d'un premier transistor ($T_1$) respectivement d'un second transistor ($T_2$) et un signal de sortie, ces trois signaux portant la valeur logique "1" lorsqu'il s'agit d'un signal rectangulaire de rapport cyclique 0,5 et la valeur logique "0" lorsqu'il s'agit d'un signal continu, Sa étant égal à 1 pour le fonctionnement en inverseur, l'un desdits transistors ($T_3$) étant un transistor de sortie sur le collecteur duquel est prélevé ledit signal de sortie ($\overline{Su}$), les signaux d'entrée Su et Sa ayant, à l'état 1, la même fréquence et étant opposés en phase, ledit circuit comportant en combinaison en premier lieu une pompe à diodes, constituée dudit premier transistor ($T_1$), de diodes (6, 7), d'un condensateur ($C_1$) et d'un condensateur de décalage de tension ($C_2$), destiné à porter le potentiel d'un premier point (A, B) à une valeur continue prédéterminée comprise entre 0 et $-V_{cc}$ lorsque Su=1 et Sa=0, en second lieu un sous ensemble constitué par ledit deuxième transistor ($T_2$) et ledit condensateur de décalage de tension ($C_2$) qui a une armature reliée au collecteur dudit deuxième transistor ($T_2$) et l'autre armature reliée audit premier point (A, B), ledit sous ensemble étant destiné à additionner audit premier point une tension alternative en opposition de phase avec Sa lorsque Sa=1, ledit premier point étant relié à la borne d'alimentation à la tension $V_{cc}$ par un groupe de deux résistances en série (26, 27) constituant un diviseur de tension dont le point commun (P) est relié à la base dudit transistor de sortie ($T_3$), et lesdites deux résistances en série ayant des valeurs telles que ledit point commun (P) est le siège d'une tension qui oscille autour de 0 si et seulement si Su=0.

3. Application à un temporisateur à l'attraction et à la chute élémentaire d'un circuit électronique de sécurité (figure 5) alimenté entre une tension continue de valeur algébrique $V_{cc}$ et la masse, comportant plusieurs transistors ($T_1$, $T_2$, $T_3$) qui ont tous le même type de conduction, ayant un signal d'entrée Su appliqué sur la base d'un premier transistor ($T_1$) et un signal de sortie ($S_s$), ces deux signaux portant la valeur logique "1" lorsqu'il s'agit d'un signal rectangulaire de rapport cyclique 0,5 et la valeur logique "0" lorsqu'il s'agit d'un signal continu, l'un desdits transistors ($T_3$) étant un transistor de sortie sur le collecteur duquel est prélevé ledit signal de sortie, la base du deuxième transistor ($T_2$) étant reliée au collecteur du premier transistor ($T_1$) par l'intermédiaire d'une résistance (28) de façon telle que les signaux appliqués aux bases des premier et deuxième transistors ($T_1$, $T_2$) soient, à l'état 1, de même fréquence et opposés en phase, comportant en combinaison en premier lieu une pompe à diodes, constituée dudit premier transistor ($T_1$), de diodes (6, 7), d'un condensateur ($C_1$) et d'un condensateur de décalage de tension ($C_2$) alimentant en tension un premier point (B), en second lieu un sous ensemble constitué par ledit deuxième transistor ($T_2$) et ledit condensateur de décalage de tension ($C_2$) qui a une armature reliée au collecteur dudit deuxième transistor ($T_2$) et l'autre armature reliée audit premier point (B), ladite pompe à diodes et ledit sous ensemble étant destinés à créer audit premier point (B) une tension qui est le résultat de l'addition d'une tension continue prédéterminée comprise entre 0 et $-V_{cc}$ et d'une tension alternative en phase avec Su, lorsque Su=1, la capacité du condensateur de décalage de tension ($C_2$) étant élevée et ledit premier point (B) étant relié à la borne d'alimentation à la tension $V_{cc}$ par un groupe de deux résistances en série (16, 17) constituant un diviseur de tension dont le point commun (P) est relié à la base dudit transistor de sortie ($T_3$), et lesdites deux résistances en série ayant des valeurs telles que ledit point commun (P) est le siège d'une tension qui oscille autour de 0 lorsque Su=1 avec un retard prédéterminé par rapport à la transition: Su=0/Su=1.

4. Application à un temporisateur à l'attraction d'un circuit électronique de sécurité, selon la revendication 3, caractérisée en ce que la tension $V_{cc}$ est appliquée audit premier point (B) après la transition: Su=1/Su=0 par un circuit de remise à zéro (RAZ) branché sur la base du premier transistor ($T_1$) par l'intermédiaire d'une résistance (3) et audit premier point (B), ce circuit RAZ comportant une pompe à diodes suivie d'un étage à deux transistors.

5. Application à un temporisateur à l'attraction d'un circuit électronique de sécurité, selon la revendication 4, caractérisée en ce qu'une mémoire positive (48) munie d'une entrée de signal utile Su et d'une entrée de signal auxiliaire Sa a ses entrées Su et Sa interverties et sa sortie reliée à l'entrée commune du temporisateur élémentaire (46) et du circuit de RAZ (47), et que ledit premier point (B) du temporisateur élémentaire est relié par l'intermédiaire d'un montage connu, à transistor deux diodes et une résistance, à une troisième entrée de la mémoire utilisée comme entrée de validation.

6. Application à un temporisateur à la chute d'un circuit électronique de sécurité, selon la revendication 1, caractérisée en ce qu'il comporte au moins un circuit porte logique "ET" (51) dont la capacité de $C_2$ est élevée, qui reçoit un signal d'entrée Su sur la base du premier transistor ($T_1$) et un signal auxiliaire Sa opposé en phase à Su lorsque Su=Sa=1 sur la base du deuxième transistor ($T_2$) et dont la sortie est reliée à l'entrée de signal auxiliaire d'une mémoire positive (53) à une entrée de signal utile (Su) et une entrée de signal auxiliaire, l'entrée de signal utile Su du circuit porte logique "ET" situé en amont étant reliée à l'entrée de signal utile de ladite mémoire dont la sortie (Ss) s'identifie à celle du temporisateur à la chute.

7. Application à un temporisateur à la chute d'un circuit électronique de sécurité, selon la revendication 6, caractérisée en ce que la sortie d'un circuit porte logique "ET", parmi plusieurs circuits portes logiques "ET" (51, 52) reliés en cascade, est reliée à l'entrée de signal utile du suivant, la sortie de chaque circuit porte "ET" étant reliée à une entrée d'un circuit porte "OU" (54) dont la sortie est reliée à ladite entrée de signal auxiliaire de ladite mémoire positive (53).

**Patentansprüche**

1. Die Verwendung einer elektronischen Sicherheitsschaltung (Fig. 4a) in einer logischen UND-Schaltung, wobei diese Sicherheitsschaltung zwischen einer Gleichspannung mit dem algebraischen Wert $V_{cc}$ und Masse gespeist wird und mehrere Transistoren ($T_1$, $T_2$, $T_3$) aufweist, die alle vom selben Leitungstyp sind und die zwei Eingangssignale Su und S'u haben, deren Amplituden im wesentlichen dieselben Werte haben und die der Basis des ersten Transistors ($T_1$) bzw. des zweiten Transistors ($T_2$) zugeführt werden, sowie ein Ausgangssignal, wobei diese drei Signale den logischen Wert "1" haben, wenn ein Rechtecksignal mit dem zyklischen Verhältnis 0,5 auftritt und den logischen Wert "0", wenn ein kontinuierliches Signal auftritt, wobei einer der genannten Transistoren ($T_3$) ein Ausgangstransistor ist, dessen Kollektor das genannte Ausgangssignal (Su · S'u) entnommen wird, wobei die Eingangssignale Su and S'u in dem Zustand 1 dieselbe Frequenz und die entgegengesetzte Phase aufweisen, wobei die genannte Schaltungsanordnung in Kombination an erster Stelle eine Diodenpumpe aufweist, die aus dem genannten ersten Transistor ($T_1$), den Dioden (6, 7), einem Kondensator ($C_1$) und einem Spannungsverschiebungskondensator ($C_2$) besteht und die dazu bestimmt ist, das Potential des ersten Punktes (A, B) auf einem vorbestimmten kontinuierlichen Wert zwischen 0 und $-V_{cc}$ zu halten, wenn Su=1 ist und S'u=0, an zweiter Stelle eine Teilzusammenstellung, die aus dem genannten zweiten Transistor ($T_2$) und dem genannten Spannungsdifferenzkondensator ($C_2$) besteht, von dem ein Anschluss mit dem Kollektor des genannten zweiten Transistors ($T_2$) verbunden ist und von dem der andere Anschluss mit dem genannten ersten Punkt (A, B) verbunden ist, wobei diese Teilzusammenstellung eine an dem genannten ersten Punkt vorhandene Wechselspannung mit entgegengesetzter Phase mit S'u addieren muss, wenn S'u=1 ist, wobei dieser erste Punkt mit der Speiseklemme mit der Spannung $V_{cc}$ verbunden ist und zwar mittels einer Gruppe zweier reihengeschalteter einen Spannungsteiler bildender Widerstände (16, 17), deren gemeinsamer Punkt (P) mit der Basis des genannten Ausgangstransistors ($T_3$) verbunden ist, wobei die genannten zwei reihengeschaltete Widerstände derartige Werte aufweisen, dass der gemeinsame Punkt (P) der Sitz einer Spannung ist, die um die 0 schwingt wenn, und nur wenn Su=S'u=1 ist.

2. Die Verwendung einer elektronischen Sicherheitsschaltung (Fig. 4a) in einem Inverter, wobei diese Sicherheitsschaltung zwischen einer Gleichspannung mit dem algebraischen Wert $V_{cc}$ und Masse gespeist wird und mehrere Transistoren ($T_1$, $T_2$, $T_3$) aufweist, die alle vom selben Leitungstyp sind und die zwei Eingangssignale Su and Sa haben, deren Amplituden im wesentlichen dieselben Werte haben und die der Basis des ersten Transistors ($T_1$) bzw. des zweiten Transistors ($T_2$) zugeführt werden, sowie ein Ausgangssignal, wobei diese drei Signale den logischen Wert "1" haben, wenn ein Rechtecksignal mit dem zyklischen Verhältnis 0,5 auftritt und den logischen Wert "0", wenn ein kontinuierliches Signal auftritt, wobei einer der genannten Transistoren ($T_3$) ein Ausgangstransistor ist, dessen Kollektor das genannte Ausgangssignal $(\overline{Su})$ entnommen wird, wobei die Eingangssignale Su und Sa in dem Zustand 1 dieselbe Frequenz und die entgegengesetzte Phase aufweisen, wobei die genannte Schaltungsanordnung in Kombination an erster Stelle eine Diodenpumpe aufweist, die aus dem genannten ersten Transistor ($T_1$), den Dioden (6, 7), einem Kondensator ($C_1$) und einem Spannungsverschiebungskondensator ($C_2$) besteht und die dazu bestimmt ist, das Potential des ersten Punktes (A, B) auf einem vorbestimmten kontinuierlichen Wert zwischen 0 und $-V_{cc}$ zu halten, wenn Su=1 ist und Sa=0, an zweiter Stelle eine Teilzusammenstellung, die aus dem genannten zweiten Transistor ($T_2$) und dem genannten Spannungsdifferenzkondensator ($C_2$) besteht, von dem ein Anschluss mit dem Kollektor des genannten zweiten Transistors ($T_2$) verbunden ist und von dem der andere Anschluss mit dem genannten ersten Punkt (A, B) verbunden ist, wobei diese Teilzusammenstellung eine an dem genannten ersten Punkt vorhandene Wechselspannung mit entgegengesetzter Phase mit Sa addieren muss, wenn Sa=1 ist, wobei dieser erste Punkt mit der Speiseklemme mit der Spannung $V_{cc}$ verbunden ist und zwar mittels einer Gruppe zweier reihengeschalteter einen Spannungsteiler bildender Widerstände (26, 27), deren gemeinsamer Punkt (P) mit der Basis des genannten Ausgangstransistors ($T_3$) verbunden ist, wobei die genannten zwei reihengeschaltete Widerstände derartige Werte aufweisen, dass der gemeinsame Punkt (P) der Sitz einer Spannung ist, die um die 0 schwingt wenn, und nur wenn Su=0 ist.

3. Verwendung einer elektronischen Sicherheitsschaltung (Fig. 5) in einer Verzögerungsschaltung, wobei diese Sicherheitsschaltung zwischen einer Gleichspannung mit dem algebraischen Wert $V_{cc}$ und Masse gespeist wird und mehrere Transistoren ($T_1$, $T_2$, $T_3$) aufweist, die alle vom selben Leitungstyp sind und die ein Eingangssignal Su aufweisen, das der Basis des ersten Transistors ($T_1$) zugeführt wird, sowie ein Ausgangssignal (Ss), wobei die zwei Signale den logischen Wert "1" aufweisen, wenn ein Rechtecksignal mit dem zyklischen Verhältnis 0,5 auftritt und den logischen Wert "0" aufweisen, wenn ein kontinuierliches Signal auftritt, wobei einer der genannten Transistoren ($T_3$) ein Ausgangstransistor ist, dessen Kollektor das genannte Ausgangssignal entnommen wird, wobei die Basis des zweiten Transistors ($T_2$) mittels eines Widerstandes (28) derart mit dem Kollektor des ersten Transistors ($T_1$) verbunden ist, dass die den Basis-Elektroden des ersten und zweiten Transistors ($T_1$, $T_2$) zugeführten Signale, in dem Zustand 1, dieselbe Frequenz und eine entgegengesetzte Phase aufweisen, wobei die Schaltungsanordnung in Kombination an erster Stelle eine Diodenpumpe aufweist, die aus dem genannten ersten Transistor ($T_1$), den Dioden (6, 7), einem Spannungsdifferenzkondensator ($C_2$) besteht, die einen ersten Punkt (B) speisen, und an zweiter Stelle eine Teilzusammenstellung, die durch den genannten zweiten Transistor ($T_2$) und den genannten Spannungsverschiebungskondensator ($C_2$) gebildet wird, von dem ein Anschluss mit dem Kollektor des genannten zweiten Transistors ($T_2$) verbunden ist und von dem der andere Anschluss mit dem genannten ersten Punkt (B) verbunden ist, wobei die genannte Diodenpumpe und die genannte Teilzusammenstellung um den genannten ersten Punkt (B) eine Spannung erzeugen, die das Ergebnis der Addition einer vorbestimmten Gleichspannung zwischen 0 und $-V_{cc}$ und einer zu Su gleichphasigen Wechselspannung ist, wenn Su=1 ist, wobei die Kapazität des Spannungsverschiebungskondensators ($C_2$) erhöht wird und der genannte Punkt (B) mittels einer Gruppe zweier reihengeschalteter Widerstände (16, 17) mit der Speiseklemme mit der Spannung $V_{cc}$ verbunden ist, wobei diese Widerstände einen Spannungsteiler bilden, deren gemeinsamer Punkt (P) mit der Basis des genannten Transistors ($T_3$) verbunden ist und wobei die zwei reihengeschaltete Widerstände derartige Werte haben, dass der genannte gemeinsame Punkt (P) der Sitz einer Spannung ist, die um 0 herumschwingt, wenn Su=1 ist mit einer vorbestimmten Verzögerung gegenüber dem Übergang: Su=0/Su=1.

4. Verwendung einer elektronischen Sicherheitsschaltung in einer Verzögerungsschaltung nach Anspruch 3, dadurch gekennzeichnet, dass die Spannung $V_{cc}$ dem genannten ersten Punkt (B) zugeführt wird und zwar nach dem Übergang: Su=1/Su=0 durch eine Nullrückstellanordnung (RAZ), der mit der Basis des ersten Transistors ($T_1$) verbunden ist und zwar mittels eines Widerstandes (3), wobei diese RAZ-Schaltung eine Diodenpumpe mit einer nachfolgenden Stufe mit zwei Transistoren aufweist.

5. Verwendung einer elektronischen Sicherheitsschaltung in einer Verzögerungsschaltung nach Anspruch 4, dadurch gekennzeichnet, dass ein positiver Speicher (48) mit einem Signaleingang des Signals Su und mit einem Signaleingang des Hilfssignals Sa seine Eingänge Su und Sa umgekehrt hat und dass der Ausgang mit dem gemeinsamen Eingang der Verzögerungsschaltung (46) und der RAZ-Schaltung verbunden ist und dass der genannte erste Punkt (B) der Verzögerungsschaltung mittels einer bekannten Konfiguration aus einem Transistor, zwei Dioden und einem Widerstand mit einem dritten Eingang des Speichers verbunden ist, wobei diesen Eingang als Erregungseingang verwendet wird.

6. Verwendung einer elektronischen Sicherheitsschaltung in einer Verzögerungsschaltung nach Anspruch 1, dadurch gekennzeichnet, dass die Schaltungsanordnung mindestens eine logische UND-Schaltung (51) aufweist, deren Kapazität von $C_2$ erhöht worden ist, wobei der Basis des ersten Transistors ($T_1$) ein Eingangssignal Su zugeführt wird und wobei der Basis des zweiten Transistors ($T_2$) ein Hilfssignal Sa mit entgegengesetzter Phase zu Su wenn Su=Sa=1 ist zugeführt wird und wobei der Ausgang mit dem Hilfssignaleingang eines positiven Speichers (53) verbunden ist mit einem Nutzsignaleingang (Su) und einem Hilfssignaleingang, wobei der Nutzsignaleingang Su der logischen UND-Schaltung stromaufwärts liegt und mit dem Nutzsignaleingang des genannten Speichers verbunden ist, dessen Ausgang (Ss) dem der Verzögerungsschaltung entspricht.

7. Verwendung einer elektronischen Sicherheitsschaltung in einer Verzögerungsschaltung nach Anspruch 6, dadurch gekennzeichnet, dass der Ausgang einer logischen UND-Schaltung von mehreren kaskadengeschalteten logischen UND-Schaltungen (51, 52) mit dem Nutzsignaleingang der nachfolgenden verbunden ist, wobei der Ausgang jeder UND-Schaltung mit einem Eingang einer ODER-Schaltung (54) verbunden ist, deren Ausgang mit dem genannten Hilfssignaleingang des genannten positiven Speichers (53) verbunden ist.

**Claims**

1. The use in a logic "AND"-gate circuit of an electronic safety circuit (Fig. 4a) which is fed in a point located between a d.c. voltage having an algebraic value $V_{cc}$ and ground, comprising a plurality of transistors ($T_1$, $T_2$, $T_3$) which all are of the same conductivity type, having two input signals $S_u$ $S'_u$ whose amplitudes have substantially equal values, which are applied to the base of a first transistor ($T_1$) and a second transistor ($T_2$), respectively, and an output signal, these three signals having the logic value "1" when a square-wave signal having a duty cycle of 0.5 is concerned and the logic value "0" when a d.c. signal is concerned, one of said transistors ($T_3$) being an output transistor from whose collector said output signal ($S_u$, $S'_u$) is taken, the input signals $S_u$ and $S'_u$ having in the 1 state the same frequency but being of opposite phases, said circuit comprising the assembly of firstly a diode pump constituted by said first transistor ($T_1$), diodes (6, 7), a capacitor ($C_1$) and a voltage shifting capacitor ($C_2$), intended to adjust the potential at a first point (A, B) to a predetermined direct voltage value comprised between 0 and $-V_{cc}$ when $S_u=1$, and $S'_u=0$, secondly a sub-assembly formed by said second transistor ($T_2$) and said voltage shifting capacitor ($C_2$) which has one armature connected to the collector of said second transistor ($T_2$) and the other armature connected to said first point (A, B), said sub-assembly being intended to add to said first point an a.c. voltage with phase opposition with $S'_u$ when $S_u=1$, said first point being connected to the power supply terminal of the voltage $V_{cc}$ via a group of two series-arranged resistors (16, 17) which constitute a voltage divider whose junction point (P) is connected to the base of said output transistor ($T_3$), and said two series-arranged resistors having values such that said junction point (P) carries a voltage which oscillates around 0, when and only then, $S_u=S'_u=1$.

2. The use in an inverter of an electronic safety circuit (Fig. 4a) which is fed in a point located between a d.c. voltage having an algebraic value $V_{cc}$ and ground, comprising a plurality of transistors ($T_1$, $T_2$, $T_3$) which are all of the same conductivity type, having two input signals $S_u$ and $S_a$ whose amplitudes have substantially equal values, which are applied to the base of a first transistor ($T_1$) and a second transistor ($T_2$), respectively, and an output signal, these three signals having the logic value "1" when a square-wave signal having a duty cycle of 0.5 is concerned and the logic value "0" when a d.c. signal is concerned, $S_a$ being equal to 1 for operation as an inverter, one of said transistors ($T_3$) being an output transistor from whose collector said output signal ($\overline{S_u}$) is taken, the input signals $S_u$ and $S_a$ having, in the 1 state the same frequency but being of opposite phases, said circuit comprising the assembly of in the first place a diode pump constituted by said first transistor ($T_1$), diodes (6, 7), a capacitor ($C_1$) and a voltage shifting capacitor ($C_2$) intended to adjust the potential at a first point (A, B) to a predetermined direct voltage value comprised between 0 and $-V_{cc}$ when $S_u=1$ and $S_a=0$, secondly a sub-assembly formed by said second transistor ($T_2$) and said voltage shifting capacitor ($C_2$) which has one armature connected to the collector of said second transistor ($T_2$) and the other armature to said first point (A, B), said sub-assembly being intended to add to said first point an a.c. voltage with phase opposition with $S_a$ when $S_a=1$, said first point being connected to the power supply terminal of voltage $V_{cc}$ via a group of two series-arranged resistors (26, 27) which constitute a voltage divider whose junction point (P) is connected to the base of said output transistor ($T_3$) and said two series-arranged resistors having values such that said junction point (P) carries a voltage which oscillates around 0 when, and only then, $S_u=0$.

3. The use in an elementary armature-attracted/released time switch of an electronic safety circuit (Fig. 5) which is fed in a point located between a d.c. voltage having an algebraic value $V_{cc}$ and ground, comprising a plurality of transistors ($T_1$, $T_2$, $T_3$) which all are of the same conductivity type, having an input signal $S_u$ which is applied to the base of a first transistor ($T_1$) and an output signal ($S_s$), these two signals having the logic value "1" when a square-wave signal having a duty cycle of 0.5 is concerned and the logic value "0" when a d.c. signal is concerned, one of said transistors ($T_3$) being an output transistor from whose collector said output signal is taken, the base of the second transistor ($T_2$) being connected to the collector of the first transistor ($T_1$) via a resistor (28) in such manner that the signals applied to the bases of the first and second transistors ($T_1$, $T_2$) have in the 1 state the same frequency but opposite phases, comprising the assembly of firstly a diode pump constituted by said first transistor ($T_1$), diodes (6, 7), a capacitor ($C_1$) and a voltage shifting capacitor ($C_2$) which applies a voltage to a first point (B) secondly a sub-assembly formed by said second transistor ($T_2$) and said voltage shifting capacitor ($C_2$) which has one armature connected to the collector of said second transistor ($T_2$) and the other armature connected to said first point (B), said diode pump and said sub-assembly being intended to produce in said first point (B) a voltage which is a result of the adding together of a predetermined d.c. voltage comprised between 0 and $-V_{cc}$ and an a.c.

voltage which is in phase with $S_u$ when $S_u=1$, the capacitance of the voltage shifting capacitor ($C_2$) being high and said first point (B) being connected to the supply terminal carrying the voltage $V_{cc}$ *via* a group of two series-arranged resistors (16, 17) which constitute a voltage divider whose junction point (P) is connected to the base of said output transistor ($T_3$), and said two series-arranged resistors having values such that said junction point (P) carries a voltage which oscillates around 0, when $S_u=1$ with a predetermined delay relative to the transition: $S_u=0/S_u=1$.

4. The use in an armature-attracted time switch of an electronic safety circuit as claimed in Claim 3, characterized in that the voltage $V_{cc}$ is applied to said first point (B) after the transition: $S_u=1/S_u=0$ *via* a reset-to-zero circuit (RAZ) connected to the base of the first transistor ($T_1$) *via* a resistor (3) and to said first point (B) this reset-to-zero circuit including a diode pump followed by a two-transistor stage.

5. The use in an armature-attracted time switch of an electronic safety circuit as claimed in Claim 4, characterized in that a positive memory (48) having a useful signal input $S_u$ and an auxiliary signal input $S_a$ has its inverted inputs $S_u$ and $S_a$ and its output connected to the common input of the elementary time switch (46) and of the reset-to-zero circuit (47), and in that said first point P of the elementary time switch is connected *via* a prior art assembly formed by a transistor having two diodes and a resistor, to a third input of the memory which is utilized as the enable input.

6. The use in an armature-released time switch of an electronic safety circuit as claimed in Claim 1, characterized in that it comprises at least one logic "AND"-gate circuit (51) in which the capacitance of capacitor $C_2$ is high, which receives an input signal $S_u$ at the base of the first transistor ($T_1$) and an auxiliary signal $S_a$, whose phase is opposite to the phase of $S_u$ when $S_u=S_a=1$ at the base of the second transistor ($T_2$) and whose output is connected to the auxiliary signal input of a positive memory (53) having a useful signal input ($S_u$) and an auxiliary signal input, the useful signal input $S_u$ of the logic "AND"-gate circuit located upstream being connected to the useful signal input of said memory whose output ($S_s$) is the same as the output of the armature-released time switch.

7. The use in an armature-released time switch of an electronic safety circuit as claimed in Claim 6, characterized in that the output of a logic "AND"-gate circuit which is one of several cascaded logic "AND"-gate circuits (51, 52) is connected to the useful signal input of the subsequent gate circuit the output of each "AND"-gate circuit being connected to an input of an "OR"-gate circuit (54), whose output is connected to said auxiliary signal input of said positive memory (53).

FIG.1a

FIG.1b

FIG.2

0 074 674

FIG.3a

FIG.3b

FIG.4a

2

FIG.4b

FIG.4c

FIG.6

FIG.5

FIG.7

FIG.8